# EUROPÄISCHE PATENTANMELDUNG

(11) **EP 0 534 498 A2**
(43) Veröffentlichungstag der Anmeldung: **31.03.1993**
(21) Anmeldenummer: 92119663.0
(22) Anmeldetag: 04.07.1989
(51) Int. Cl.: H03K 9/06

(54) **Verfahren und Vorrichtung zur Wandlung eines Frequenzsignals in ein Spannungssignal**

(30) Priorität: 28.11.1988 DE 3840073
(62) Teilanmeldung aus: 89112180.8
(71) Anmelder: ROBERT BOSCH GMBH, 70442 Stuttgart (DE)
(72) Erfinder: Ciulin, Dan, CH-1012 Pully (CH)

(57) **Zusammenfassung**

Der Erfindung liegt die Aufgabe zugrunde, ein Verfahren zur Wandlung eines Frequenzsignals in ein Spannungssignal anzugeben, das die bei den Wandlern gemäß dem Stand der Technik auftretende Unsymmetrie der Kennlinie vermeidet.

Die Lösung der Aufgabe besteht darin, daß das an einem Eingang (19) des Frequenz-Spannungswandlers (26) liegende Frequenzsignal mit einer Referenzfrequenz (fᵣ) in ein höheres Frequenzsignal verschoben wird. Die Phase dieses Frequenzsignals wird mit der Phase eines Signal verglichen, das über einen symmetrischen Spannungs-Frequenzwandler (26) aus dem Signal am Ausgang (28) des Frequenz-Spannungswandlers erhalten und ebenfalls in ein höheres Frequenzsignal verschoben wird. Die Phase des Vegleichssignals wird dann mit der Phase der Referenzfrequenz verglichen.

Die Figur zeigt ein Blockschaltbild eines Frequenz-Spannungswandlers.

## Beschreibung

Die Erfindung geht von einem Verfahren und einer Vorrichtung nach dem Oberbegriff des Anspruchs 1 aus.

Es ist eine Vorrichtung zur Wandlung eines Frequenzsignals in ein Spannungssignal bekannt (Jerzy Gorski-Popiel, Frequency Synthesis: Techniques and Applications, IEEE Press, 1975, Seite 117), bei der eine in einem Phasendetektor einer PLL-Schaltung erzeugte Differenzfrequenz durch ein Filter in eine Spannung umgewandelt wird, die als Steuerspannung einen spannungsgesteuerten Oszillator nachsteuert.

Der Erfindung liegt die Aufgabe zugrunde, einen Frequenz-Spannungswandler zu schaffen, der eine symmetrische Frequenz-Spannungskennlinie aufweist, wobei der Frequenz-Spannungswandler die Wandlung auch für momentane Frequenzen durchführen soll.

Diese Aufgabe wird bei einem Verfahren und einer Vorrichtung zur Wandlung eines Frequenzsignals in ein Spannungssignal durch die Merkmale des Anspruchs 1 gelöst. Ein mit der Erfindung erzielbarer Vorteil besteht insbesondere darin, daß durch den symmetrischen Spannungs-Frequenzwandler in Verbindung mit den anderen Merkmalen des Anspruchs 1 eine symmetrische Frequenz-Spannungskennlinie erzielt wird. Als symmetrischer Spannungs-Frequenzwandler eignet sich ein Wandler nach der Patentanmeldung EP 89112180.8.

Vorteilhafte Weiterbildungen der Erfindung ergeben sich aus den abhängigen Ansprüchen.

Ausführungsbeispiele der Erfindung sind in der Zeichnung dargestellt und werden in der nachfolgenden Beschreibung näher erläutert. Es zeigen:
- Fig. 1: ein Blockschaltbild einer Vorrichtung zur Wandlung eines Spannungssignals in ein Frequenzsignal,
- Fig. 2: eine Frequenz-Spannungskennlinie der Vorrichtung nach Fig. 1 und
- Fig. 3: ein Blockschaltbild einer Vorrichtung zur Wandlung eines Frequenzsignals in ein Spannungssignal.

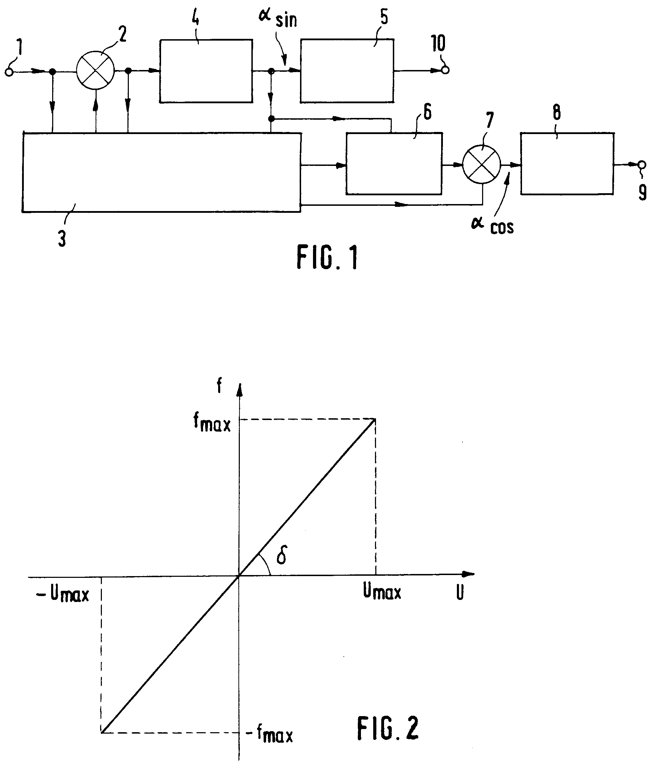

Ein für den Aufbau eines erfindungsgemäßen Frequenz-Spannungswandlers geeigneter Spannungs-Frequenzwandler hat nach Fig. 1 einen Eingang 1, der mit einem Multiplizierer 2 und einem logischen Schaltkreis 3 verbunden ist. Der logische Schaltkreis besteht vorzugsweise aus mehreren Komparatoren und einem digitalen Netzwerk, bestehend aus UND-Gattern, ODER-Gattern, einem X ODER-Gatter und einem Flip-Flop. Ein Ausgang des logischen Schaltkreises 3 ist an einen weiteren Eingang des Multiplizierers 2 angeschlossen. Der Ausgang des Multiplizierers steht mit dem Eingang eines Integrierers 4 in Verbindung, dessen Ausgang an einen Sinuswandler 5, den logischen Schaltkreis 3 und einen Addierer 6 angeschlossen ist. An einen weiteren Eingang des Addierers 6 liegt ein Ausgang des logischen Schaltkreises 3. Der Ausgang des Addierers 6 ist mit einem zweiten Multiplizierer 7 verbunden, an dessen zweiten Eingang ein weiterer Ausgang des logischen Schaltkreises liegt. An den Ausgang des zweiten Multiplizierers 7 ist ein weiterer Sinuswandler 8 angeschlossen.

Der in Fig. 1 dargestellte Spannungs-Frequenzwandler weist eine symmetrische Frequenz-Spannungskennlinie nach Fig. 2 auf.

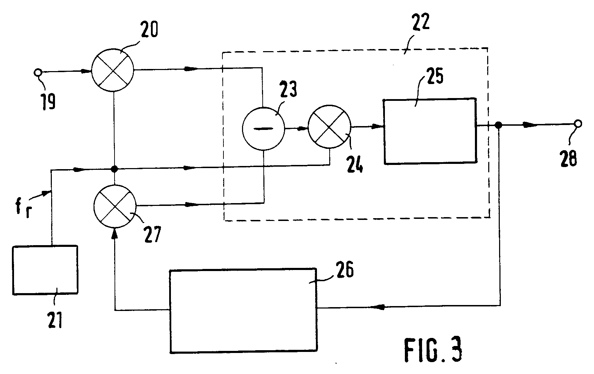

Mit Hilfe des Spannungs-Frequenzwandlers nach Fig. 1 läßt sich nach Fig. 3 ein Frequenz-Spannungswandler herstellen, der eine symmetrische Frequenz-Spannungskennlinie aufweist, die der Kennlinie nach Fig. 2 entspricht, wobei die Y-Achse die Spannung und die X-Achse die Frequenz darstellt. Der Frequenz-Spannungswandler nach Fig. 3 weist einen ersten Mischer 20 auf, dessen Eingänge einerseits mit der Eingangsklemme 19 und andererseits mit einem Referenzoszillator 21, der eine Referenzfrequenz fᵣ liefert, verbunden ist. Der Ausgang des Mischers liegt an einem Synchrondetektor 22 an, der die Reihenschaltung aus einem Differenzbildner 23, einem zweiten Mischer 24 und einem Tiefpaß 25 aufweist. Der zweite Mischer 24 ist ebenfalls mit dem Referenzoszillator 21 verbunden. In einer Rückschleife ist ein Spannungs-Frequenzwandler nach Fig. 1 an den Ausgang des Synchrondetektors 22 geschaltet, wobei der Ausgang des Spannungs-Frequenzwandlers 26 mit einem dritten Mischer 27 verbunden ist, an dessen anderem Ende der Referenzoszillator 21 liegt. Der Ausgang des dritten Mischers 27 steht mit dem zweiten Eingang des Differenzbildners 23 in Verbindung.

Die Funktionsweise des in Fig. 3 dargestellten Frequenz-Spannungswandlers ist wie folgt:
Das an der Klemme 19 anliegende Eingangssignal wird in dem ersten Mischer 20 mit der höheren Referenzfrequenz fᵣ, die in etwa mindestens fünf- bis zehnmal größer ist als die Maximalfrequenz des Eingangssignals, multipliziert, das heißt es wird nach höheren Frequenzen hin verschoben. Dies ist notwendig, um ein einwandfreies Arbeiten des Synchrondetektors 22 zu gewährleisten und die Zeitkonstante der als phasenempfindlicher Regelkreis ausgebildeten Schaltung klein zu halten. Dadurch hat der Tiefpaß 25 eine Zeitkonstante von drei bis fünf Perioden des Referenzoszillators 21 und nicht des Eingangssignals. Wenn die Referenzfrequenz fᵣ groß genug gewählt wird, so kann das Eingangssignal in so viele Zeitintervalle eingeteilt werden, wie in Betracht gezogen werden können, so daß die Steuerung in "Phase" realisiert werden kann.

Über den Differenzbildner 23 wird die "Phase" des Eingangssignals mit der "Phase" des mittels des Spannungs-Frequenzwandlers 26 rekonstruierten Signals verglichen, und die resultierende "Phase" wird von dem analogen "Phasendetektor", der vom zweiten Mischer 24 und vom Tiefpaß 25 gebildet wird, in eine Spannung umgesetzt. Dieser "Phasendetektor" vergleicht die Phase des Referenzoszillators 21 mit der Phase des Ausgangssignals des als Operationsverstärker ausgebildeten Differenzbildners 28.

Diese Anordnung rekonstruiert jedes Signal, wenn seine maximale Momentanfrequenz mindestens geringer als die Referenzfrequenz fᵣ ist, zum Beispiel fünf- bis zehnmal, um die Bedingung der "Phase" zu erfüllen, und wenn seine Amplitude nicht die maximale Amplitude am Spannungs-Frequenzwandler 26 übersteigt.

Wegen der Symmetrie liegt am Ausgang des Spannungs-Frequenzwandlers 26 das gleiche Signal an wie am Eingang 19, wenn das Eingangssignal nicht den Bereich der Systemparameter übersteigt. Für diesen Fall kann die Schaltung nach Fig. 3 als wirklich symmetrischer Frequenz-Spannungswandler betrachtet und aufgrund der oben beschriebenen Eigenschaften gegebenenfalls als wirklicher Phasen-Frequenzdemodulator verwendet werden.

## Patentansprüche

1. Verfahren zur Wandlung eines Frequenzsignals in ein Spannungssignal, **dadurch gekennzeichnet,** daß das ein Frequenzsignal bildende Eingangssignal mittels einer Referenzfrequenz nach höheren Frequenzen verschoben wird und seine Phase mit der Phase des über einen symmetrischen Spannungs-Frequenzwandler rückgeführten, in die höheren Frequenzen verschobenen Ausgangssignals verglichen wird und daß die Phase des Vergleichssignals mit der Phase der Referenzfrequenz verglichen wird.

2. Vorrichtung zur Wandlung eines Frequenzsignals in ein Spannungssignal unter Anwendung des Verfahrens nach Anspruch 1, dadurch gekennzeichnet, daß ein erster Mischer (20) vorgesehen ist, der einerseits das Eingangssignal erhält und andererseits mit einem Referenzoszillator (21) verbunden ist, daß ein dritter Mischer (27) vorgesehen ist, der einerseits mit dem Referenzoszillator (21) und andererseits mit einem in eine Rückkopplungsschleife geschalteten Spannungs-Frequenzwandler verbunden ist, daß die Ausgänge des ersten und des dritten Mischers (20, 27) mit einem Differenzbildner (23) verbunden sind, dessen Ausgang ebenso wie der des Referenzoszillators (21) an einen Phasendetektor (24, 25) angeschlossen ist, wobei der Ausgang des Phasendetektors an den Eingang des Spannungs-Frequenzwandlers (26) rückgeführt ist.

3. Vorrichtung nach Anspruch 2, dadurch gekennzeichnet, daß der Phasendetektor (24, 25) einen mit dem Differenzbildner (23) und dem Referenzoszillator (21) verbundenen zweiten Mischer (24) und einen an ihn anschließenden Tiefpaß (25) aufweist.

4. Vorrichtung nach Anspruch 2 oder 3, dadurch gekennzeichnet, daß die Referenzfrequenz des Referenzsignals mindestens fünfbis zehnmal größer ist als die größte Momentanfrequenz des Eingangssignals.
